# DEMANDE DE BREVET EUROPEEN

(11) **EP 0 801 466 A1**
(43) Date de publication de la demande: **15.10.1997**
(21) Numéro de dépôt: 97400745.2
(22) Date de dépôt: 01.04.1997
(51) Int. Cl.: H03F 3/08

(54) **Amplificateur adapteur haute impédance pour recevoir des signaux hyperfréquences à très large bande d'une source de courant capacitive à haute impédance telle qu'une photodiode**

(30) Priorité: 11.04.1996 FR 9604525
(71) Demandeur: DASSAULT ELECTRONIQUE, F-92210 Saint-Cloud (FR)
(72) Inventeur: Dueme, Philippe, 91140 Villejust (FR); Nicole, Pierre, 92210 Saint Cloud (FR)
(74) Mandataire: Nicolle, Olivier

(57) **Abrégé**

L'amplificateur adaptateur haute impédance comprend un premier transistor à effet de champ (T1), monté en drain commun, dont la grille (G1) est reliée à une première borne (BK) de la photodiode (PHD), et dont la source (S1) est reliée à une deuxième borne (BA) de la photodiode (PHD) à travers un circuit (CBO, LBO) ayant des propriétés capacitives et inductives choisies pour supprimer les effets capacitifs de la photodiode sur toute la très large bande de fréquences, pour découpler le signal continu du signal hyperfréquence, et pour minimiser au voisinage de la fréquence de coupure et au-delà, l'impédance globale constituée par l'impédance de la source de courant, l'impédance du circuit et l'impédance de sortie du premier transistor.

## Description

La présente invention concerne un amplificateur adaptateur haute impédance pour recevoir des signaux hyperfréquences à très large bande d'une source de courant capacitive à haute impédance telle qu'une photodiode.

Elle trouve une application dans la fabrication de circuits intégrés monolithiques hyperfréquences, destinés en particulier pour la transmission de signaux hyperfréquences à très large bande sur fibres optiques.

Les systèmes hyperfréquences dans le domaine du radar, de la guerre électronique et des applications de télécommunications, augmentent continuellement leur niveau de complexité, et utilisent de plus en plus des liaisons hyperfréquences.

Compte tenu des avantages conférés par les fibres optiques, notamment en termes d'encombrement et de perte, les liaisons hyperfréquences utilisent de plus en plus des fibres optiques et des transducteurs optoélectroniques, tels que des diodes laser, et des photodiodes.

Néanmoins, les photodiodes se comportent généralement comme une source de courant capacitive à haute impédance dans laquelle une capacité parasite se trouve montée en parallèle sur une très haute impédance.

Il en résulte une fréquence de coupure dont la valeur est proportionnelle à la valeur de cette capacité, ce qui limite d'autant la largeur de la bande de fréquences de la liaison optique.

La présente invention a pour objet de remédier à ce problème. Ainsi, elle vise à fournir un amplificateur adaptateur haute impédance capable d'assurer une adaptation haute impédance, tout en conservant un gain plat sur toute la très large bande de fréquences.

Elle porte sur un amplificateur adaptateur haute impédance pour recevoir des signaux hyperfréquences à très large bande d'une source de courant à haute impédance, à polarisation continue.

Selon une définition générale de l'invention, l'amplificateur comprend, un premier transistor à effet de champ, monté en drain commun, dont la grille est reliée à une première borne de la source de courant capacitive, et dont la source est reliée à une deuxième borne de la source de courant à travers un circuit ayant des propriétés capacitives et inductives choisies pour supprimer les effets capacitifs de la source de courant, sur toute la très large bande de fréquences, découpler le signal continu du signal hyperfréquence et minimiser au voisinage de la fréquence de coupure et au-delà, l'impédance globale constituée par l'impédance de la source de courant, l'impédance du circuit et l'impédance de sortie du premier transistor, et la très large bande de fréquences s'étend d'au moins 1 GHz jusqu'à au moins 18 GHz.

Le premier transistor est ici monté en drain commun selon un montage à amorce ou à contre réaction active, appelé encore "bootstrap", dans lequel la source du transistor est reliée à l'entrée de la source de courant à travers une capacité et une ligne de type selfique montée en série pour supprimer les effets capacitifs de la source de courant, découpler le signal continu du signal hyperfréquence, et minimiser au voisinage de la fréquence de coupure et au-delà, l'impédance globale constituée par l'impédance de la source de courant, l'impédance de la ligne et l'impédance de sortie dudit premier transistor.

Avantageusement, l'amplificateur comprend en outre un second transistor à effet de champ, dont la grille est connectée à la source du premier transistor, et dont la source est appliquée à une charge d'impédance plus faible que celle de la source de courant.

Le second transistor est ici monté également en drain commun, afin d'assurer l'adaptation d'impédance entre la source de courant à haute impédance et une charge d'impédance normalisée.

On utilise déjà ce genre de montage à contre réaction active, par exemple dans le Brevet EP 306798, dans lequel une capacité est connectée entre la source d'un transistor d'un système d'amplification et la cathode d'une photodiode de détection pour réduire le rapport du signal à bruit. Mais, ce genre de montage est uniquement utilisé pour des applications basse fréquence telles que la détection de lumière ou le balayage de codes barres. Or, les problèmes rencontrés en hyperfréquence sont totalement différents et plus difficiles à résoudre que ceux rencontrés en basse fréquence. Il en résulte que cette contre réaction active connue en basse fréquence n'est pas, pour l'homme du métier, directement et avec évidence transposable au domaine hyperfréquence.

D'autres caractéristiques et avantages de l'invention apparaîtront à la lumière de la description détaillée ci-après et des dessins annexés dans lesquels :
- la figure 1 est un schéma de principe d'un amplificateur adaptateur haute impédance à très large bande de fréquences selon l'invention ;
- la figure 2 est un dessin de masque de l'amplificateur de la figure 1, en technologie de circuit intégré monolithique hyperfréquences selon l'invention ;
- les figures 3A à 3D représentent des liaisons à fibres optiques avec ou sans amplificateur adaptateur haute impédance selon l'invention ; et
- les figures 4 à 6 représentent des courbes illustrant le bilan des liaisons des dispositifs décrits en référence aux figures 3A à 3D.

Les dessins annexés comportent pour l'essentiel des éléments de caractère certain. Ils pourront donc non seulement servir à mieux faire comprendre la description détaillée ci-après, mais aussi contribuer à la définition de l'invention, le cas échéant.

L'une des caractéristiques essentielles d'une photodiode utilisée comme récepteur dans les transmissions de signaux hyperfréquences sur fibres optiques, est qu'elle se comporte comme une source de courant capacitive à haute impédance, avec une capacité parasite en parallèle sur une très haute impédance.

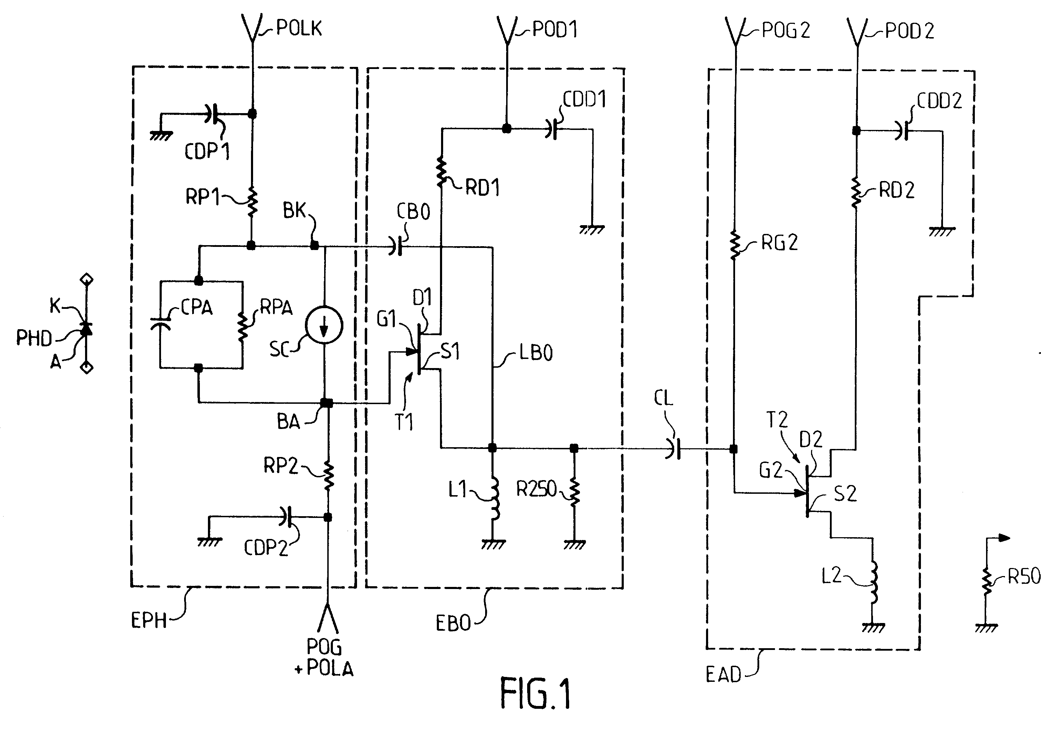

Sur la figure 1, sur le schéma équivalant d'une photodiode connue PHD, on trouve la source de courant SC avec une capacité CPA montée en parallèle sur une très haute impédance RPA.

Par exemple, la valeur capacitive de la capacité CPA est de l'ordre de 0,2 picofarad et l'impédance RPA (résistance) est de l'ordre de 2000 Ohms.

La cathode K de la photodiode est polarisée par un circuit de polarisation (non représenté) capable de délivrer une tension de polarisation continue POLK. Cette tension de polarisation POLK est appliquée à une borne BK de la source de courant SC à travers une résistance de polarisation RP1, montée en série.

Une capacité de découplage CDP1 est prévue pour découpler la puissance hyperfréquence. L'une des armatures de la capacité de découplage CDP1 est mise à la masse tandis que l'autre armature est reliée à une borne de la résistance RP1.

De même, l'anode A de la photodiode PHD est polarisée par un circuit de polarisation (non représenté) propre à délivrer une tension de polarisation continue pour l'anode POLA. Cette tension est appliquée à la borne BA de la source de courant SC à travers une résistance de polarisation RP2. Une capacité de découplage CDP2 est également prévue pour découpler la puissance hyperfréquence. L'une des armatures de la capacité CDP2 est reliée à l'une des bornes de la résistance RP2 tandis que l'autre armature de la capacité CDP2 est appliquée à la masse.

Le circuit constitué par la capacité CPA et la résistance RPA est monté en parallèle entre les bornes BK et BA de la source de courant.

L'ensemble de ces éléments constitue l'étage photodiode EPH.

La Demanderesse s'est posée le problème de fournir à cet étage photodiode, un amplificateur adaptateur haute impédance capable de supprimer les effets néfastes engendrés par la capacité parasite CPA, et fournir aussi une adaptation haute impédance.

La solution proposée selon l'invention consiste à appliquer à un tel étage EPH, un premier étage EBO à base d'un transistor en drain commun pour supprimer, à la fréquence de résonance, les effets néfastes de la capacité parasite de la photodiode.

L'étage EBO est appelé montage à amorce, ou à contre réaction active, appelé encore "bootstrap" dans lequel le premier transistor se comporte comme un amplificateur à gain unité ramenant à l'entrée de la source de courant, la même tension en phase et en module qu'à sa sortie, ce qui permet d'appliquer au circuit formé par la capacité CPA et la résistance RPA une tension sensiblement nulle. Un tel montage est équivalent à ouvrir le circuit RPA/CPA, ce qui supprime ainsi les effets capacitifs engendrés par un tel circuit, à la fréquence de résonance.

Par ailleurs, la Demanderesse a observé qu'au voisinage de la fréquence de résonance et au-delà, la ligne de type selfique engendre une résonance, ce qui permet d'annuler la partie imaginaire de l'impédance globale constituée par l'impédance de la photodiode, l'impédance de la ligne et l'impédance de sortie du transistor.

En pratique, ce montage à contre réaction active consiste à relier la source S1 du transistor T1 à la borne BK de la source de courant SC à travers un circuit comprenant une ligne LBO et une capacité CBO.

L'étage à contre réaction active EBO est complété par un circuit de polarisation propre à délivrer une tension de polarisation pour le drain du premier transistor T1. Cette tension de polarisation POD1 est appliquée directement au drain D1 du transistor T1.

Très avantageusement, pour éviter que le transistor T1 oscille spontanément, il est prévu une résistance de stabilité RD1 dont une borne est reliée au drain D1 et dont l'autre borne est reliée au circuit de polarisation qui délivre la tension POD1. Une capacité de découplage CDD1 est également prévue, avec une armature reliée au drain D1 à travers la résistance RD1 et une autre armature mise à la masse.

La grille G1 du transistor T1 est reliée à la borne BA de la source de courant SC. Avantageusement, le circuit de polarisation de la grille (non représenté) applique la tension de polarisation POG1 à travers la résistance RP2.

Par exemple, la valeur élémentaire des capacités CDP1, CDP2 et CDD1 est de 5 picofarads.

Les valeurs ohmiques des résistances RP1 et RP2 sont respectivement de 1000 Ohms et 200 Ohms.

La valeur ohmique de la résistance de stabilité RD1 est par exemple de l'ordre de 5 à 35 Ohms.

L'étage à contre réaction active est complété par une inductance L1, ayant une borne mise à la masse, et l'autre borne reliée à la source S1 du transistor T1.

De même, une résistance R250 d'une valeur ohmique de l'ordre de 250 Ohms est également prévue avec une borne reliée à la source S1 du transistor T1, et une autre borne à la masse.

Très avantageusement, il est prévu, selon l'invention, d'appliquer au premier étage EBO, un second étage EAD articulé autour d'un second transistor T2 en drain commun pour effectuer une adaptation haute impédance.

Plus précisément, la sortie de l'étage à contre réaction active EBO est appliquée au second étage adaptateur d'impédance EAD à travers une capacité de liaison CL de 5 picofarads.

La grille G2 du transistor T2 est reliée à la sortie du premier étage EBO. La source S2 du transistor T2 est mise à la masse à travers une inductance L2 d'environ 4 nanoHenry.

La sortie de l'étage adaptateur d'impédance EAD est appliquée à une charge d'impédance normalisée R50 de valeur 50 Ohms.

Le transistor T2 monté en drain commun entre l'étage à contre réaction active et la charge, permet de réaliser une adaptation d'impédance.

Les deux fonctions du dispositif selon l'invention sont séparées afin de mieux les contrôler au moyen des deux transistors distincts T1 (contre réaction active) et T2 (adaptation d'impédance).

L'étage adaptateur d'impédance EAD est complété par un circuit de polarisation (non représenté) propre à délivrer la tension de polarisation POG2 de la grille G2 du transistor T2. Cette tension est délivrée à travers une résistance RG2 reliée à la grille G2. La valeur ohmique de la résistance RG2 est par exemple de 5000 Ohms.

Le drain D2 du transistor T2 est polarisé par un circuit de polarisation (non représenté) capable de délivrer une tension de polarisation POD2. Cette tension est appelée directement au drain D2. Pour éviter que le transistor T2 oscille spontanément, il est prévu, comme pour le transistor T1, une résistance RD2 dont une borne est reliée au drain D2 et dont l'autre borne est reliée au circuit de polarisation délivrant la tension POD2. Une capacité de découplage CDD2 complète avantageusement le montage avec une armature reliée au drain D2 à travers la résistance RD2 et une autre armature mise à la masse.

Par exemple, la valeur capacitive de la capacité CDD2 est de 5 picofarads et la valeur ohmique de la résistance RD2 est de l'ordre de 5 à 35 Ohms.

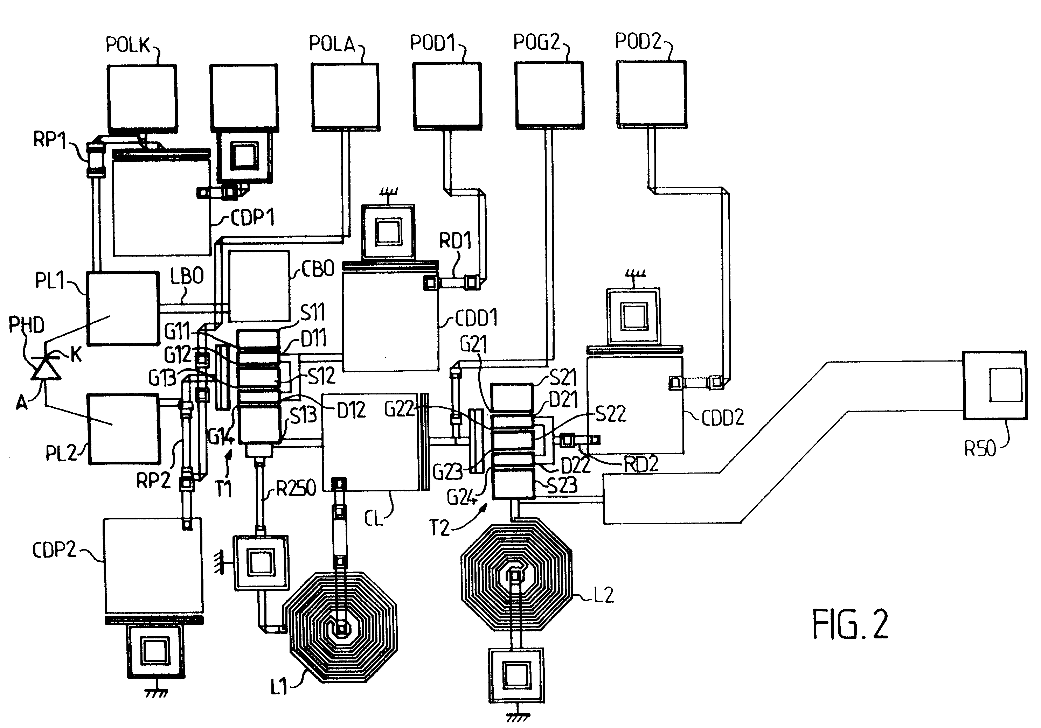

En référence à la figure 2, l'homme du métier reconnaît le dessin de masque de l'amplificateur adaptateur haute impédance décrit en référence à la figure 1, en technologie de circuit intégré monolithique en hyperfréquences, appelé encore MMIC pour Monolithic Microwave Integrated Circuit.

On y retrouve les moyens essentiels et constitutifs de l'amplificateur selon l'invention.

Il convient de remarquer que ce dessin de masque a l'avantage de fournir un amplificateur peu encombrant, simple et facile à mettre en oeuvre avec un haut rendement de fabrication.

Il est à noter que les transistors à effet de champ sont à quatre doigts de grille (G11, G12, G13, G14 pour T1), trois doigts de source (S11, S12, S13 pour T1) et deux doigts de drain (D11, D12 pour T1). Ils sont du type HEMT pour High Electron Mobility Transistor, fabriqués selon le procédé THOMSON/TCS de type VLN02/HEMT.

La photodiode PHD est appliquée à deux plots PL1 et PL2. Ces deux plots PL1 et PL2 constituent les deux bornes BK et BA de la source de courant décrite en référence à la figure 1.

La longueur de la ligne de bootstrap LBO est choisie de telle sorte que les propriétés inductives en hyperfréquences de cette ligne annulent les effets capacitifs de la source de courant capacitive à haute impédance (c'est-à-dire du circuit formé par la capacité CPA et la résistance RPA) à la fréquence de résonance.

En pratique, l'un des doigts de source S11 du transistor T1, et le plot PL1 sont agencés de telle sorte que la ligne LBO a une longueur la plus courte possible entre ledit doigt de source S11 et le plot PL1.

La Demanderesse a observé qu'une ligne LBO d'une longueur de l'ordre de 200 à 400 µm, présente des propriétés inductives équivalentes à quelques dixièmes de nanoHenry et suppriment les effets capacitifs mentionnés ci-avant.

Par ailleurs, la capacité CBO assure ici avantageusement le découplage du signal continu servant à la polarisation de la photodiode, du signal hyperfréquence à traiter. La capacité CBO a une valeur d'environ 2 picofarads. Elle est accolée au doigt de source S11 et reliée à la ligne LBO.

En ce qui concerne les autres éléments constitutifs de l'amplificateur, ils répondent à des règles de dessins connues.

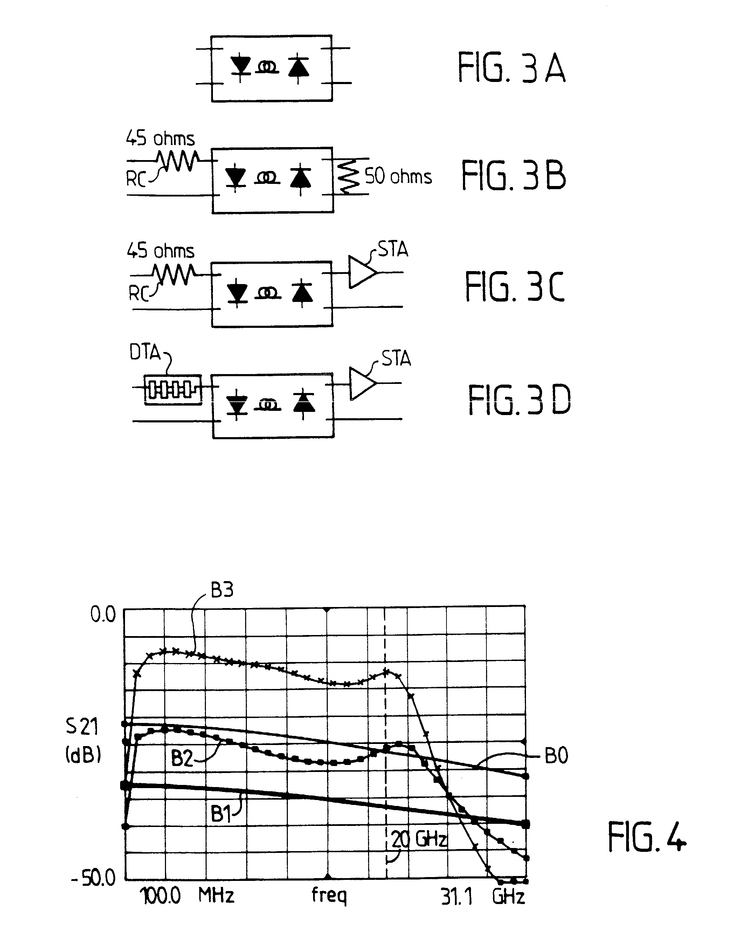

Sur les figures 3A à 3D, sont représentées schématiquement des liaisons sur fibres optiques FO entre un émetteur électro-optique de type diode laser LA et un récepteur électro-optique du type photodiode PH.

En correspondance à ces liaisons, sont représentées sur les figures 4 à 6, des courbes représentant les bilans de ces liaisons, notamment en ce qui concerne les coefficients S21, S11 et S22, en décibels.

Sur la figure 3A, la liaison optique est de type télécommunication sans adaptation d'impédance ni en émission, ni en réception.

Sur la figure 3B, une adaptation basse impédance, selon la technique connue par résistance complémentaire de 45 Ω, est appliquée à l'émission tandis qu'une résistance de 50 Ω est appliquée à la réception, en parallèle sur la photodiode.

Sur la figure 3C, une adaptation basse impédance, selon la technique connue par résistance complémentaire RC de 45 Ohms est appliquée à l'émission, tandis qu'en réception, une adaptation basse impédance est réalisée conformément à l'amplificateur spécifique adaptateur haute impédance STA selon l'invention.

Sur la figure 3D, est représentée une liaison sur fibres optiques entre une diode laser adaptée en basse impédance grâce à un amplificateur distribué DTA décrit dans la Demande de Brevet déposée par la Demanderesse le même jour que la présente Demande, et portant sur un amplificateur distribué adaptateur basse impédance pour émetteur optoélectronique de signaux hyperfréquences à très large bande, et une photodiode adaptée grâce à l'amplificateur adaptateur haute impédance STA selon l'invention.

Sur les figure 4 à 6, la courbe BO illustre le bilan de la liaison décrite en référence à la figure 3A, la courbe B1 illustre le bilan de la liaison de la figure 3B, la courbe B2 illustre le bilan de la liaison de la figure 3C, et la courbe B3 illustre le bilan de la liaison décrite en référence à la figure 3D.

L'axe des abscisses représente la fréquence en gigahertz et l'axe des ordonnées est en décibels.

Le coefficient S21 (figure 4) est un coefficient de transmission qui exprime le gain en puissance du transfert d'énergie de la diode laser vers la photodiode.

Le coefficient S11 caractérise l'adaptation d'impédance de la liaison optique vue de l'émission.

Le coefficient S22 caractérise l'adaptation d'impédance de la liaison optique vue de la réception.

Plus les coefficients S11 et S22 présentent un gain négatif important en décibels, meilleure est l'adaptation.

Les courbes BO en figures 4 à 6 montrent qu'il y a un gain d'environ -20 dB à -30 dB, en l'absence totale d'adaptation d'impédance en émission et en réception. Cependant, cette configuration est inutilisable dans la pratique à cause des très fortes désadaptations (S11 et S22 proches de 0 dB).

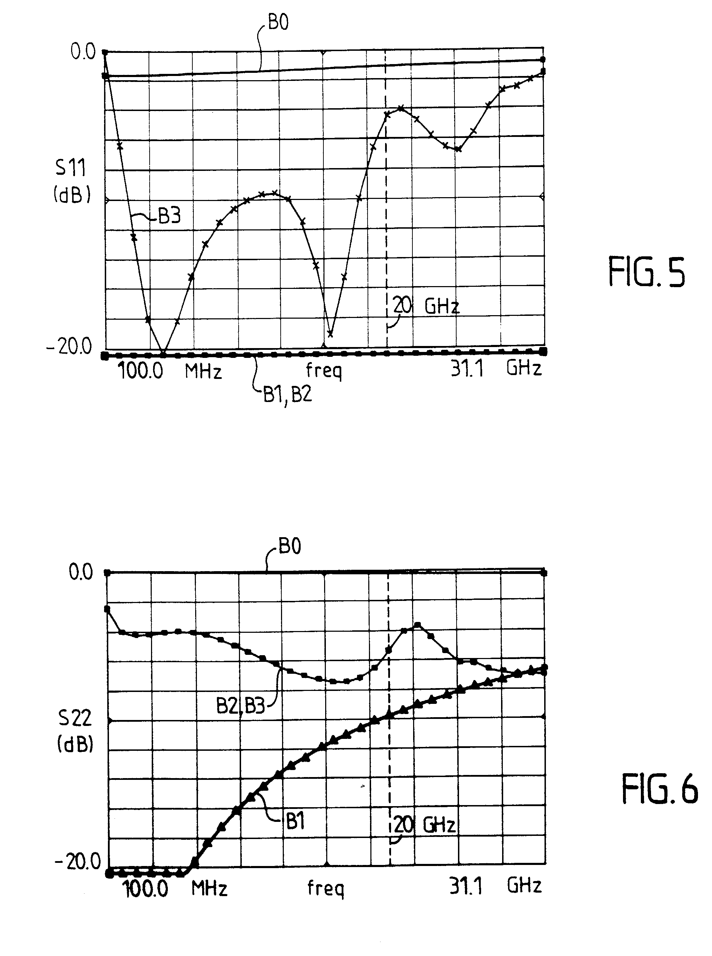

Les courbes B1 en figures 4 et 6 montrent qu'il y a moins de gain par rapport à BO avec une bonne adaptation, qui rend cette configuration utilisable. La courbe B1 est ici la référence en gain de l'état de la technique.

Les courbes B2 en figures 4 à 6 montrent qu'il y a une adaptation acceptable et un gain supérieur au gain de référence.

Enfin, les courbes B3 en références aux figures 4 à 6, montrent un excellent gain sur la bande d'au moins I GHz jusqu'à au moins 18 GHz avec une bonne adaptation en émission et en réception.

## Revendications

1. Amplificateur adaptateur haute impédance pour recevoir des signaux hyperfréquences à très large bande d'une source de courant capacitive à haute impédance à polarisation continue (PHD), ledit amplificateur étant caractérisé en ce qu'il comprend un premier transistor à effet de champ (T1), monté en drain commun, dont la grille (G1) est reliée à une première borne (BK) de la source de courant (PHD), et dont la source (S1) est reliée à une deuxième borne (BA) de la source de courant (PHD) à travers un circuit (CBO, LBO) ayant des propriétés capacitives et inductives choisies pour supprimer les effets capacitifs de la source de courant sur toute la très large bande de fréquences, pour découpler le signal continu du signal hyperfréquence, et pour minimiser au voisinage de la fréquence de coupure et au-delà, l'impédance globale constituée par l'impédance de la source de courant, l'impédance du circuit et l'impédance de sortie du premier transistor, et en ce que la très large bande de fréquences s'étend d'au moins 1 GHz jusqu'à au moins 18 GHz.

2. Amplificateur selon la revendication 1, caractérisé en ce que le circuit monté en série entre la source (S1) du premier transistor (T1) et la seconde borne (BK) de la source de courant, comprend une capacité (CBO) de valeur choisie et une ligne (LBO) de dimensions choisies.

3. Amplificateur selon la revendication 1 ou la revendication 2, caractérisé en ce qu'il comprend en outre un second transistor à effet de champ (T2), monté en drain commun, dont la grille (G2) est connectée à la source (S1) du premier transistor (T1), et dont la source (S2) est appliquée à une charge (R50) d'impédance plus faible que celle de la source de courant capacitive, afin de réaliser une meilleure adaptation haute impédance.

4. Amplificateur selon la revendication 1, caractérisé en ce qu'il comprend une première résistance (RD1) de valeur ohmique choisie et reliée entre le drain (D1) du premier transistor (T1) et le circuit de polarisation du drain (D1), la valeur ohmique de la première résistance (RD1) étant choisie afin d'éviter que l'amplificateur oscille spontanément.

5. Amplificateur selon la revendication 3, caractérisé en ce qu'il comprend une seconde résistance (RD2) de valeur ohmique choisie, et reliée entre le drain (D2) du second transistor (T2) et le circuit de polarisation dudit drain (D2), la valeur ohmique de la seconde résistance (RD2) étant choisie afin d'éviter que l'amplificateur oscille spontanément.

6. Amplificateur selon l'une des revendications précédentes, caractérisé en ce que la source de courant capacitive (PHD) est une photodiode d'impédance d'environ quelques milliers d'Ohms, tandis que la charge a une impédance de 50 Ohms, en ce que la cathode de la photodiode constitue la première borne (BK) de la source de courant capacitive, et en ce que l'anode de la photodiode constitue la seconde borne (BA) de la source de courant capacitive.

7. Utilisation de l'amplificateur selon l'une des revendications précédentes à la fabrication de circuits intégrés monolithiques micro-ondes, destinés à la transmission de signaux hyperfréquences sur fibres optiques.
